Europäisches Patentamt

European Patent Office

Office européen des brevets

(19)

(11) Veröffentlichungsnummer: **0 025 209**

**A2**

(12) EUROPÄISCHE PATENTANMELDUNG

(21) Anmeldenummer: 80105238.2

(22) Anmeldetag: 03.09.80

(51) Int. Cl.³: **H 05 K 7/02**

(30) Priorität: 11.09.79 DE 2936621

(43) Veröffentlichungstag der Anmeldung:
18.03.81 Patentblatt 81/11

(84) Benannte Vertragsstaaten:
AT BE CH FR GB IT LI NL SE

(71) Anmelder: BROWN, BOVERI & CIE Aktiengesellschaft
Mannheim
Kallstadter Strasse 1
D-6800 Mannheim Käfertal(DE)

(72) Erfinder: Viebig, Klaus, Dr., Dipl.-Ing.
Zwischen den Bächen 14
D-6902 Sandhausen(DE)

(74) Vertreter: Kempe, Wolfgang, Dr. et al,
c/o Brown, Boveri & Cie AG Postfach 351
D-6800 Mannheim 1(DE)

(54) Busline-Anordnung für Elektronik-Systeme in Blockbauform.

(57) Die Zusammenschaltung von Elektronik-Blöcken durch ein Busline-System erfolgt dadurch, daß die Blöcke Öffnungen in den Seitenwänden aufweisen, in die die Busline-Anordnung eingebracht wird. Da die äußeren Seitenwände der Blöcke keine Öffnungen aufweisen, kann dadurch die Busline-Anordnung mechanisch gehalten werden. Auf der Busline-Anordnung können auch noch zusätzliche elektronische Bauelemente aufgebracht werden.

EP 0 025 209 A2

B R O W N , B O V E R I & CIE    AKTIENGESELLSCHAFT

Mannheim                                    7. Sept. 1979

Mp.-Nr. 611/79                             ZFE/P3-NL/Ma

"Busline-Anordnung für Elektronik-Systeme in Blockbauform"

Die Erfindung bezieht sich auf eine Busline-Anordnung für
Elektronik-Systeme in Blockbauform, wobei die Busline-Anordnung zur elektrischen Verbindung der Blöcke untereinander
dient und Steckverbinder den elektrischen Kontakt zwischen
Busline-Anordnung und den Blöcken herstellen.

Die Erfindung liegt auf dem Gebiet der speicherprogrammierbaren Steuerungen.

Um speicherprogrammierbare Steuerungen an Stelle von üblichen
mechanischen Schützensteuerungen einzusetzen, müssen diese Anordnungen erhebliche Vorteile aufweisen. Bekannt ist, elektronische Baugruppen, die in Blöcke zusammengefaßt sind, auf einer Hutprofilschiene aufzubringen. In den Blöcken sind unterschiedliche Baugruppen angeordnet, die je nach Verwendungszweck wahlweise zusammengeschaltet werden. Die Blöcke bestehen meistens aus einem Kunststoffgehäuse und sind so geformt, daß die innerhalb liegenden Baugruppen (Leiterplatten) ausreichend mit Kühlluft versorgt werden. Bei speicherprogrammierbaren Steuerungen werden üblicherweise neben einem Stromversorgungsblock noch ein Zentralblock mit dem Speichermodul, sowie Ein- und Ausgabeblöcke und Zeitblöcke eingesetzt. Die Blöcke werden auf DIN-genormte (beispielsweise 19 Zoll) Profilleisten aufgerastet und können leicht wieder abgenommen werden. Zum Verbinden der einzelnen Blöcke untereinander ist eine Busline-Anordnung vorgesehen, die zum Beispiel aus einer Flachleitung besteht und vorzugsweise zwischen die Schenkel der Hutprofilschiene eingelegt ist. Über Steckverbindungen ist die Busline-Anordnung mit den einzelnen Blöcken verbunden. Es ergeben sich dadurch Merkmale wie problemorientierte Steuerungsgeräte, modulare Erweiterbarkeit, Austauschbarkeit der Blöcke, Abführung der Verlustwärme, abgeschirmte Normgehäuse und erhebliche Kosteneinsparung. Der Aufbau derartiger Automatisierungssysteme in Blockform ist beschrieben in Siemens-Energietechnik, 1979, Heft 4, Seite 129 bis 132.

Durch die Führung der Busline außerhalb der Blöcke zwischen den Schenkeln der Hutprofilschiene ergeben sich aber Nachteile bei der mechanischen Anordnung. Nach dem Herausziehen der Blöcke liegt die Busline mit den Kontaktstellen ungeschützt, so daß Staub und Feuchtigkeit eindringen können. Auch elektromagnetische Störfelder können ungehindert einwirken. Durch die Anordnung der Busline innerhalb der Hutprofilschiene ist die Abmessung der Schiene ebenfalls vorgeschrieben. Durch das geringe Gewicht der kunststoffummantelten Blöcke könnte eine kleinere Profilschiene eingesetzt werden, wenn die Busline mechanisch anders geführt wäre.

Speicherprogrammierbare Steuerungen werden üblicherweise in genormten Gehäusen (z.B. 19 Zoll Gehäusen) angeboten. Je nach Anwender und Einsatz sind Grundaufbau und Erweiterungen möglich. Zu einem Grundaufbau gehört aber immer das Gehäuse mit der eingebauten Busline. Je nach Ausbaugrad können zusätzliche Baugruppen eingeschoben werden. Bei einfachen Anwendungsbereichen wird aber in den vorhandenen Norm-Gehäusen nur ein sehr geringer Platz gebraucht, so daß noch viel ungenutzter Raum vorhanden ist. Dadurch liegt nicht nur die Busline mit ihren Kontakten an vielen Stellen ungeschützt, das gesamte Steuerungssystem wird auch unnötig groß und teuer.

Es ist deshalb Aufgabe der Erfindung, die Blöcke innerhalb eines Elektronik-Systems über eine geschützt angebrachte Busline-Anordnung auf einfache und kostengünstige Art zu verbinden.

Erfindungsgemäß wird dies dadurch erzielt, daß die Busline-Anordnung durch in den Seitenwänden der Blöcke vorhandene Öffnungen in die Blöcke einbringbar ist und daß die Blöcke nach Einbringen der Busline-Anordnung untereinander mechanisch verbindbar sind. Die beiden äußeren Blöcke weisen keine Öffnungen in den äußeren Seitenwänden auf, so daß die Busline-Anordnung mechanisch gehalten wird. In einer Ausgestaltung besteht die Busline-Anordnung aus einer Leiterplatte, auf die außer den Steckverbindern elektrische und/oder elektronische Bauelemente aufbringbar sind.

Vorteilhaft ist, daß Elektronik-Systeme von beliebigen Abmessungen in kompakter Form zusammengestellt werden können. Die Busline-Anordnung ist nachträglich in die Blöcke einbringbar und liegt geschützt im Inneren der Blöcke.

Die Blöcke werden je nach Bedarf zusammengestellt. Dann wird die Busline-Anordnung von unten in die vorhandenen Öffnungen der Blöcke eingeschoben und stößt so an die äußeren Seitenwände der Endblöcke. Die Busline-Anordnung kann aber auch in vorhandene Nuten eingerastet werden, die auf den Seitenwänden der Endblöcke aufgebracht sind. Die Blöcke werden anschließend mechanisch miteinander verbunden, so daß sich ein kompaktes, kleines und geschütztes Blocksystem ergibt, daß auf eine vorhandene Schiene gesteckt wird. Erweiterungen des Systems sind problemlos möglich, dabei bleiben die Abmessungen aber weiterhin gering.

Durch Führung der Busline-Anordnung innerhalb der Blöcke ist ein optimaler Schutz vor Feuchtigkeit, Staub und elektromagnetischen Störfeldern gegeben. Durch die geschützte interne Führung der Busline-Anordnung können in vorteilhafter Weise auch elektronische Komponenten auf der Busline-Anordnung angebracht werden.

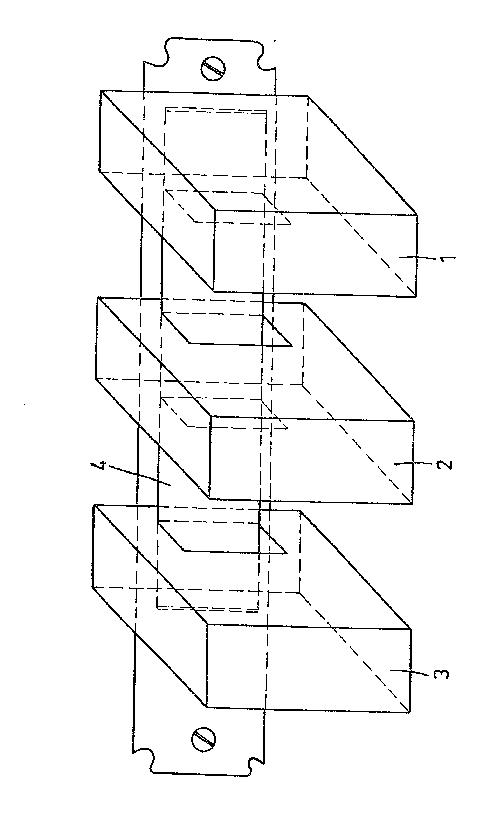

Ein Ausführungsbeispiel der Erfindung wird nachstehend anhand der Zeichnung näher erläutert.

Zur besseren Übersicht ist zwischen den einzelnen Blöcken Platz gelassen. In der Wirklichkeit werden die Blöcke aber aneinandergereiht und mechanisch verbunden.
Eine speicherprogrammierbare Steuerung soll aus drei Blöcken aufgebaut werden. Der innere Block 2 weist an seinen beiden Seitenwänden Öffnungen auf. Die beiden äußeren Blöcke 1 und 3 haben diese Öffnungen nur auf der dem Block 2 zugewandten Seite. Die Außenseiten der Blöcke 1 und 3 sind geschlossen. Eine Busline-Anordnung 4 in Leiterplattenform wird jetzt von unten in die Blöcke eingeschoben. Im Inneren der Blöcke und auf der Busline-Anordnung angebrachte Steckverbinder stellen die erforderlichen elektrischen Verbindungen her. Diese Kontaktanordnungen sind in der Zeichnung nicht dargestellt.

7.9.1979          - 5 -          611/79

Die Busline-Anordnung ist hier als Leiterplatte ausgeführt, auf die neben den Steckverbindern in vorteilhafter Weise zusätzliche elektronische Bauelemente aufgebracht sind. Die Busline-Anordnung kann aber auch als Flachbandkabel ausgeführt sein. In der einfachsten Form kann die Busline-Anordnung in beliebiger Länge vorliegen, die dann je nach Bedarf auf die richtige Länge geschnitten wird.

Die in die Blöcke 1,2,3 eingeführte Busline-Anordnung 4 wird mechanisch durch die geschlossenen äußeren Seitenwände der Blöcke 1 und 3 gehalten. Einen weiteren mechanischen Halt der Busline-Anordnung üben die Steckverbindungen aus. Nach Einbringen der Busline-Anordnung 4 werden die Blöcke durch nicht gezeigte Verbindungen, beispielsweise Klemmen, zusammengefügt, so daß eine mechanisch stabile Blockbauform entsteht. Diese Blockbauform wird dann auf eine vorhandene Profilschiene 5 aufgeklemmt.

Mit geringstmöglichem Montageaufwand läßt sich so eine speicherprogrammierbare Steuerung aus beliebig vielen Einzelblöcken zusammenstellen. In freier Bauweise kann sogar auf die Profilschiene 5 verzichtet werden. Die zusammengefügten Blöcke können dann durch seitliche Laschen auf einen Untergrund festgeschraubt werden.

Patentansprüche

1. Busline-Anordnung für Elektroniksysteme in Blockbauform, wobei die Busline-Anordnung zur elektrischen Verbindung der Blöcke untereinander dient und Steckverbinder den elektrischen Kontakt zwischen Busline-Anordnung und den Blöcken herstellen, dadurch gekennzeichnet, daß die Busline-Anordnung (4) durch in Seitenwänden der Blöcke (1,2,3) vorhandene Öffnungen in die Blöcke einbringbar ist und daß die Blöcke (1,2,3) nach Einbringen der Busline-Anordnung (4) untereinander mechanisch verbindbar sind.

2. Busline-Anordnung nach Anspruch 1, dadurch gekennzeichnet, daß die beiden äußeren Blöcke (1,3) keine Öffnungen in den äußeren Seitenwänden aufweisen, so daß die BuslineAnordnung (4) mechanisch gehalten wird.

3. Busline-Anordnung nach Anspruch 1, dadurch gekennzeichnet, daß die Busline-Anordnung aus einer Leiterplatte besteht, auf die außer den Steckverbindern elektrische und/oder elektronische Bauelemente aufbringbar sind.